# EUROPEAN PATENT APPLICATION

(11) **EP 2 677 557 A1**
(43) Date of publication of application: **25.12.2013**
(21) Application number: 12172934.7
(22) Date of filing: 21.06.2012
(51) Int. Cl.: H01L 33/62

(54) **Method for bonding LED wafer, method for manufacturing LED chip and bonding structure**

(71) Applicant: Industrial Technology Research Institute, Chutung Hsinchu 31040 (TW)
(72) Inventor: Lin, Hsiu-Jen, 30274 Hsinchu County (TW); Lin, Jian-Shian, 26066 Yilan County (TW); Chen, Shau-Yi, 64865 Yunlin County (TW); Tsai, Jen-Hui, 300 Hsinchu City (TW)
(74) Representative: von Kreisler Selting Werner

(57) **Abstract**

A method for bonding an LED wafer, a method for manufacturing an LED chip, and a bonding structure are provided. The method for bonding an LED wafer includes the following steps. A first metal film is formed on an LED wafer. A second metal film is formed on a substrate. A bonding material layer whose melting point is lower than or equal to about 110°C is formed on the surface of the first metal film. The LED wafer is placed on the substrate.

The bonding material layer is heated at a pre-solid reaction temperature for a pre-solid time to perform a pre-solid reaction. The bonding material layer is heated at a diffusion reaction temperature for a diffusing time to perform a diffusion reaction, wherein the melting points of the first and the second inter-metallic layers after diffusion reaction are higher than about 110°C.

## Description

### BACKGROUND

### Technical Field

The technical field relates to a method for bonding an LED wafer, a method for manufacturing an LED chip and a bonding structure.

### Description of the Related Art

The mainstream light emitting diode (LED) chip has three types of structure, namely, the sapphire base structure, the flip-chip structure and the vertical structure. The sapphire base, having the features of superior mechanical properties and lower cost, has become the mainstream gallium nitride (GaN) growth substrate.

As for the LED chip with vertical structure, the LED wafer and a thermo and electricity conductive material are bonded first, and then the sapphire base is lifted off with excimer laser. The LED chip with vertical structure, having the features of high heat dissipation, high light emitting efficiency, and no current clustering, has become a mainstream structure for high-power LED chips.

### SUMMARY

The disclosure is directed to a method for bonding an LED wafer, a method for manufacturing an LED chip, and a bonding structure.

According to one embodiment, a method for bonding a light emitting diode (LED) wafer is provided. The bonding method is for bonding an LED wafer and a substrate. The bonding method includes the following steps. A first metal film is formed on the LED wafer. A second metal film is formed on the substrate. A bonding material layer is formed on the surface of the first metal film, wherein the melting point of the bonding material layer is lower than or equal to about 110°C. The LED wafer is placed on the substrate for enabling the bonding material layer to contact the second metal film. The bonding material layer is heated at a pre-solid reaction temperature for a pre-solid time to perform a pre-solid reaction for forming a first inter-metallic layer between the first metal film and the bonding material layer and forming a second inter-metallic layer between the second metal film and the bonding material layer. The bonding material layer is heated at a diffusion reaction temperature for a diffusing time to perform a diffusion reaction, wherein the melting points of the first and the second inter-metallic layers after diffusion reaction are higher than about 110°C.

According to another embodiment, a method for manufacturing a light emitting diode (LED) chip is provided. The method for manufacturing an LED chip includes the following steps. A first metal film is formed on an LED wafer. A second metal film is formed on a substrate. A bonding material layer is formed on the surface of the first metal film, wherein the melting point of the bonding material layer is lower than or equal to about 110°C. The LED wafer is placed on the substrate for enabling the bonding material layer to contact the second metal film. The bonding material layer is heated at a pre-solid reaction temperature for a pre-solid time to perform a pre-solid reaction for forming a first inter-metallic layer between the first metal film and the bonding material layer and forming a second inter-metallic layer between the second metal film and the bonding material layer. The bonding material layer is heated at a diffusion reaction temperature for a diffusing time to perform a diffusion reaction, wherein the melting points of the first and the second inter-metallic layers after diffusion reaction are higher than about 110°C. A base of the LED wafer is lifted off and the LED wafer and the substrate are singulated to form a plurality of LED chips.

According to an alternative embodiment, a bonding structure is provided. The bonding structure includes a substrate, a second metal film, a second inter-metallic layer, a first inter-metallic layer, a first metal film and an LED wafer. The second metal film is located on the substrate. The material of the second metal film comprises gold (Au), silver (Ag), copper (Cu), nickel (Ni) or a combination thereof. The second inter-metallic layer is located on the second metal film. The first inter-metallic layer is located on the second inter-metallic layer. The material of each of the first inter-metallic layer and the second inter-metal copper indium tin (Cu-In-Sn) inter-metal, nickel indium tin (Ni-In- Sn) inter-metal, nickel bismuth (Ni-Bi) inter-metal, gold indium (Au-In) inter-metal, silver indium (Ag-In) inter-metal, silver tin (Ag-Sn) inter-metal, gold bismuth (Au-Bi) inter-metal or a combination thereof. The first metal film is located on the first inter-metallic layer. The material of the first metal film comprises gold (Au), silver (Ag), copper (Cu), nickel (Ni) or a combination thereof. The LED wafer is located on the first metal film.

The above and other aspects of the disclosure will become better understood with regard to the following detailed description of the non-limiting embodiment(s). The following description is made with reference to the accompanying drawings.

### BRIEF DESCRIPTION OF THE DRAWINGS

FIG. 1 shows a flowchart of a method for bonding a light emitting diode (LED) wafer and a substrate and a method for manufacturing an LED chip according to an embodiment of the disclosure; and

FIGS. 2 to 8 show the procedure in each step of FIG. 1.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

### DETAI LED DESCRIPTION

Below, exemplary embodiments will be described in detail with reference to accompanying drawings so as to be easily realized by a person having ordinary knowledge in the art. The inventive concept may be embodied in various forms without being limited to the exemplary embodiments set forth herein. Descriptions of well-known parts are omitted for clarity, and like reference numerals refer to like elements throughout.

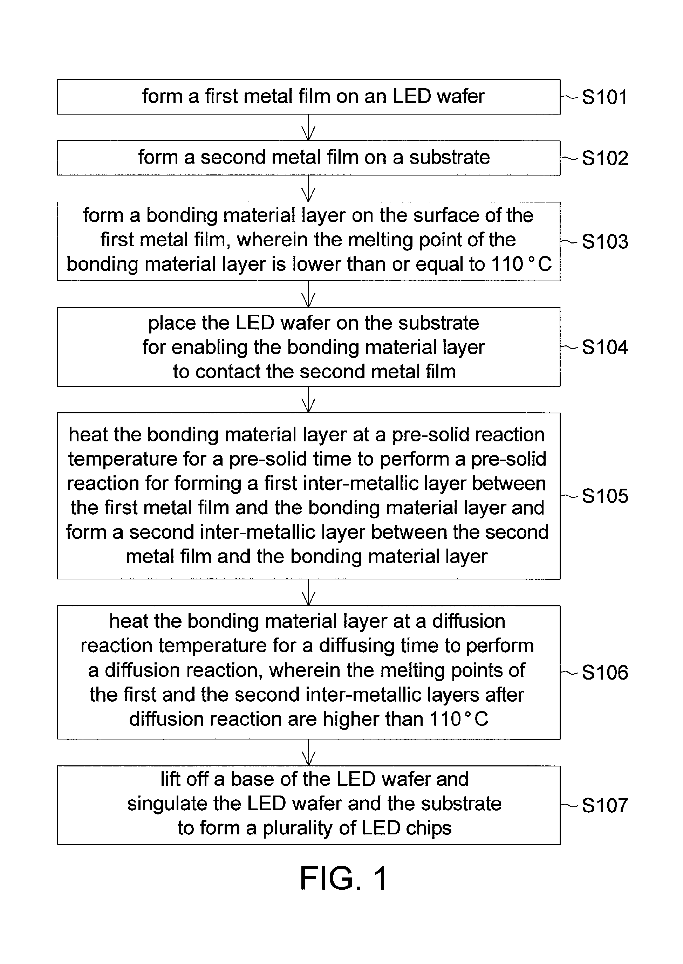

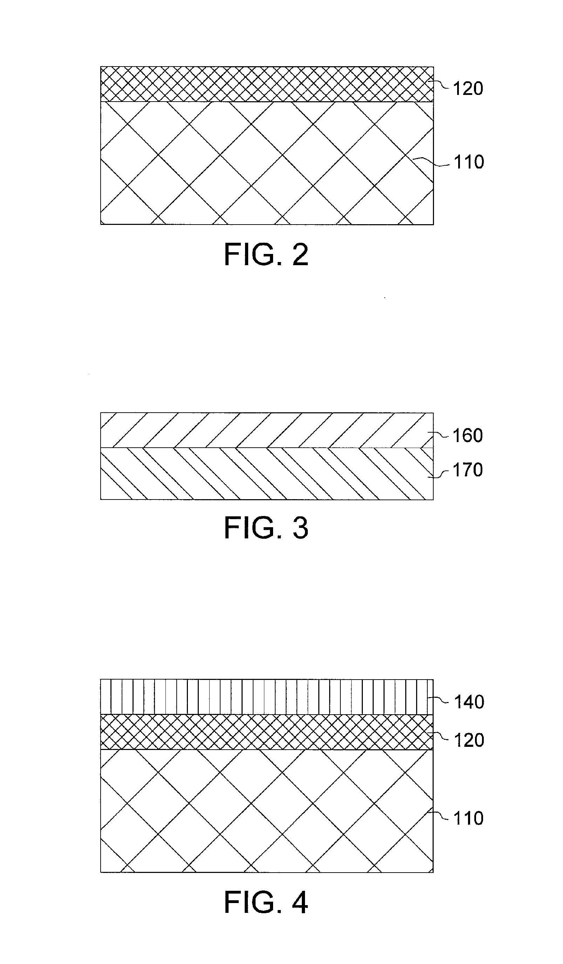

Please refer to FIGS. 1 to 8. FIG. 1 shows a flowchart of a method for bonding a light emitting diode (LED) wafer 110 and a substrate 170 and a method for manufacturing an LED chip 300 according to an embodiment of the disclosure. FIGS. 2 to 8 show detailed procedures in each step of FIG. 1.

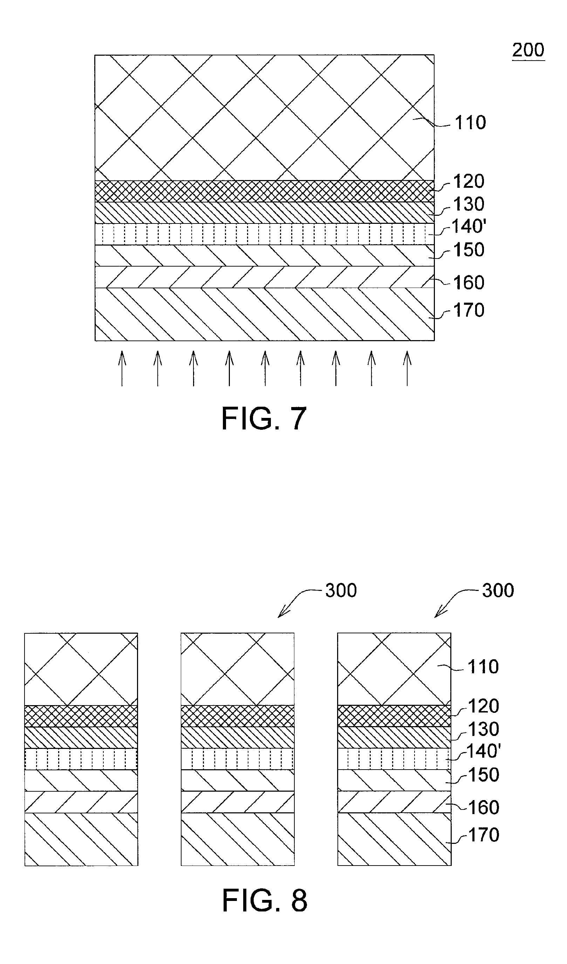

Steps S101 to S106 relate to a method for bonding an LED wafer 110 and a substrate 170. As indicated in FIG. 7, a bonding structure 200 for bonding an LED wafer 110 and a substrate 170 is formed after step S106 is completed.

Steps S101 to S107 relate to a method for manufacturing an LED chip 300. As indicated in FIG. 8, a plurality of LED chips 300 are formed after step S107 is completed.

Please refer to FIG. 2. In step S101, a first metal film 120 is formed on an LED wafer 110. The LED wafer 110 includes, for example, a base, an N-type semiconductor layer, a luminous material layer and a P-type semiconductor layer. The luminous material layer is disposed between the N-type semiconductor layer and the P-type semiconductor layer to form a P-I-N structure. The base is such as a sapphire base. The material of the N-type semiconductor layer and the P-type semiconductor layer comprises gallium nitride (GaN), gallium nitride indium (GalnN), aluminum indium gallium phosphide (AllnGaP), aluminum nitride (AIN), indium nitride (InN), indium gallium arsenic nitride (InGaAsN), indium gallium phosphide nitride (InGaPN) or a combination thereof. In one embodiment, the first metal film 120 can be formed on a surface of the LED wafer 110 opposite to the base.

The spectrum of the light emitted from the LED wafer 110 can be a spectrum of any visible light whose wavelength ranges 380 to 760 nanometer (nm), or other wavelength range. Moreover, the LED wafer 110 can be realized by such as a sapphire base structure, a vertical structure or a flip-chip structure.

The material of the first metal film 120 comprises gold (Au), silver (Ag), copper (Cu), nickel (Ni) or a combination thereof. In the present step, the first metal film 120 can be formed on the LED wafer 110 by way of electroplating, sputtering or e-gun evaporation, and the thickness of the first metal film 120 is such as but not limited to 0.1 to 2.0 micrometers (um). For example, the thickness of the first metal film 120 ranges 0.5 to 1.0 micrometers (um).

Referring to FIG. 3, in step S102, a second metal film 160 is formed on a substrate 170. The material of the substrate 170 comprises gold (Au), silver (Ag), copper (Cu), nickel (Ni), molybdenum (Mo), silicon (Si), silicon carbide (SiC), aluminum nitride (AIN), a metal ceramics composite material or a combination thereof.

The material of the second metal film 160 comprises gold (Au), silver (Ag), copper (Cu), nickel (Ni) or a combination thereof. In the present step, the second metal film 160 can be formed on the substrate 170 by way of electroplating, sputtering or evaporation, and the thickness of the second metal film 160 is such as but not limited to about 0.1 to 2.0 micrometers (um). For example, the thickness of the second metal film 160 ranges about 0.5 to 1.0 micrometers (um).

Referring to FIG. 4, in step S103, a bonding material layer 140 is formed on the surface of the first metal film 120. The material of the bonding material layer 140 comprises bismuth indium (Bi-In), bismuth indium zinc (Bi-In-Zn), bismuth indium tin (Bi-In-Sn), bismuth indium tin zinc (Bi-In-Sn-Zn) or a combination thereof. The melting point of the bonding material layer 140 is such as but not limited to be lower than or equal to about 110°C. For example, the melting point of bismuth indium (Bi-In) is about 110°C, the melting point of bismuth indium zinc (for example, Bi-25In-18Zn (The weight ratio of Bi:In:Zn is 1:25:18.)) is about 82°C, the melting point of bismuth indium tin zinc (for example, Bi-20In-30Sn-3Zn (The weight ratio of Bi:In:Sn:Zn is 1:20:30:3.)) is about 90°C, and the melting point of bismuth indium zinc (for example, Bi-33In-0.5Zn (The weight ratio of Bi:In:Zn is 1:33:0.5.)) is about 110°C. In the present step, the bonding material layer 140 can be formed on the first metal film 120 by way of electroplating, sputtering or evaporation, and the thickness of the bonding material layer 140 is such as but not limited to about 0.2 to 5.0 micrometers (um). For example, the thickness of the bonding material layer 140 ranges about 0.5 to 1.5 micrometers (um).

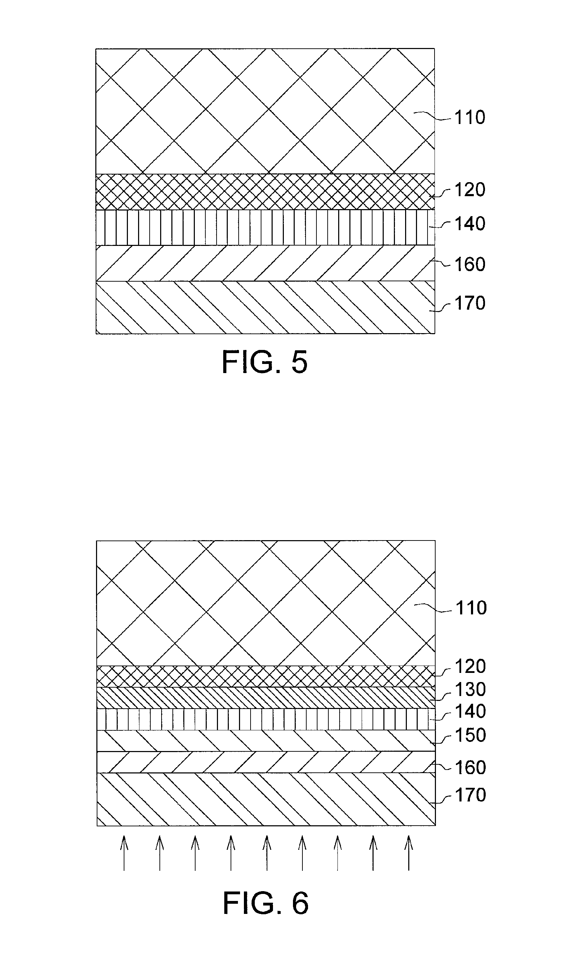

Please refer to FIG. 5. The LED wafer 110 is placed on the substrate 170 for enabling the bonding material layer 140 to contact the second metal film 160.

Please referring to FIG. 6, in step S105, the bonding material layer 140 is heated at a pre-solid reaction temperature for a pre-solid time to perform a pre-solid reaction for forming a first inter-metallic layer 130 between the first metal film 120 and the bonding material layer 140 and forming a second inter-metallic layer 150 between the second metal film 160 and the bonding material layer 140. The pre-solid reaction of the present embodiment of the disclosure can be realized by a liquid-solid reaction.

The purpose of the present step is for pre-solidifying the LED wafer 110 and the substrate 170 according to the current alignment relationship to facilitate subsequent processing. The pre-solid reaction temperature can be equal to or higher than the melting point of the bonding material layer 140. For example, the pre-solid reaction temperature is equal to or higher than about 80°C or ranges about 80 to 200°C. In one example, the pre-solid time is about 0.1 second to 10 minutes. In one example, the pre-solid time can be very short so that the said alignment relationship is effectively maintained lest an unexpected effect such as thermo-stress can be generated on the LED wafer 110.

If the material of the bonding material layer 140 is bismuth indium tin (Bi-In-Sn), then the pre-solid reaction temperature can be equal to higher than about 82°C. The bonding material layer 140 can be heated by way of laser heating, thermal wind heating, infra-red light heating, thermal pressure heating, or ultra-sound added thermal pressure heating. The heating can be achieved by increasing the environment temperature to the pre-solid reaction temperature, directly heating the bonding material layer 140, or directly heating the substrate 170 for transferring the heat to the bonding material layer 140. Taking FIG. 6 as an example, the bottom of the substrate 170 is directly heated by laser and the pre-solid reaction temperature is about 85°C.

The pre-solid time can be adjusted according to the situation of the pre-solid reaction. That is, a sufficient size of first inter-metallic layer 130 can be formed between the first metal film 120 and the bonding material layer 140. Moreover, the pre-solid reaction can be terminated when a sufficient size of second inter-metallic layer 150 is formed between the second metal film 160 and the bonding material layer 140 and the required time for the pre-solid reaction is exactly the pre-solid time. In the present step, the pre-solid reaction could be terminated immediately when the first inter-metallic layer 130 and the second inter-metallic layer 150 are still very thin; alternatively, the pre-solid reaction could be terminated until the first inter-metallic layer 130 and the second metal layer 150 are thicker.

The materials of the first inter-metallic layer 130 and the second inter-metallic layer 150 are determined according to the materials of the first metal film 120, the bonding material layer 140 and the second metal film 160. The material of each of the first inter-metallic layer 130 and the second inter-metallic layer 150 comprises copper indium tin (Cu-In-Sn) inter-metal (for example, Cu₆In₅ or Cu₆Sn₅), nickel indium tin (Ni-In-Sn) inter-metal, nickel bismuth (Ni-Bi) inter-metal, gold indium (Au-In) inter-metal, silver indium (Ag-In) inter-metal (for example, Ag₂In or AgIn₂), silver tin (Ag-Sn) inter-metal (for example, Ag₃Sn), gold bismuth (Au-Bi) inter-metal (for example, Au₂Bi), gold tin (Au-Sn) inter-metal (for example, AuSn₄) or a combination thereof.

Referring to FIG. 7, in step S106, the bonding material layer 140 is heated at a diffusion reaction temperature for a diffusing time to perform a diffusion reaction. The diffusion reaction can be realized by a liquid-solid reaction or a solid-solid reaction. The diffusion reaction temperature can be equal to or higher than the melting point of the bonding material layer 140 if the diffusion reaction is a liquid-solid reaction. For example, the diffusing time is about 0.5 to 3 hours if the diffusion reaction temperature ranges about 80 to 200°C.

If the diffusion reaction is a solid-solid reaction, the diffusion reaction temperature is lower than the melting point of the bonding material layer 140. Since the diffusion reaction temperature is lower than the melting point of the bonding material layer 140, the diffusion reaction in the present step will not have any effect on the alignment relationship after the pre-solid reaction. For example, the diffusion reaction temperature ranges about 40 to 80°C, the diffusing time is about 0.5 to 3 hours.

The diffusion reaction temperature is higher than the melting point of the bonding material layer 140 if the diffusion reaction is a liquid-solid reaction. Since the diffusion reaction temperature is higher than the melting point of the bonding material layer 140, the diffusion reaction in the present step can further include positioning the LED wafer 110 and the substrate 170 to increase the precision in aligning the LED wafer 110 and the substrate 170.

The diffusion reaction in the present step can be adjusted according to the setting of the diffusion reaction temperature. The diffusing time can be shortened if the diffusion reaction temperature is higher and can be prolonged if the diffusion reaction temperature is lower. In the present embodiment of the disclosure, the diffusing time is such as about 0.5 to 3 hours.

The diffusion reaction in the present step is for enabling the alloy elements of the bonding material layer 140, the first metal film 120 and the second metal film 160 to be diffused to each other. The diffusing time can be set to the required time for most of the alloy elements of the bonding material layer 140 to be diffused. That is, the present step can be performed until the diffusion reaction is completed.

The present step can adopt batch processing in the manner of thermal wind heating, oven heating, infra-red light heating or thermal plate heating.

After the diffusion reaction, the melting points of the first inter-metallic layer 130 and the second inter-metallic layer 150 are such as higher than about 110°C. If the first inter-metallic layer 130 and the second inter-metallic layer 150 are formed by different materials, their melting points will be different accordingly. For example, the melting point of a silver indium (Ag-In) inter-metal (for example, Ag₂In or AgIn₂) is at least above 250°C, the melting point of a silver tin (Ag-Sn) inter-metal (for example, Ag₃Sn) is at least above 450°C, the melting point of a gold bismuth (Au-Bi) inter-metal is at least above 350°C, and the melting point of a gold tin (Au-Sn) inter-metal is at least above 250°C.

After the diffusion reaction, a part of the bonding material layer 140 may be left between the first inter-metallic layer 130 and the second inter-metallic layer 150 for forming an inter layer 140' (as indicated in FIG. 7). In an embodiment, the bonding material layer 140 may be completely reacted and vanish. The material of the inter layer 140' comprises tin (Sn), bismuth (Bi), indium (In), zinc (Zn) or a combination thereof.

Taking FIG. 7 as an example, after steps S101 to S106 are completed, the bonding structure 200 for bonding the LED wafer 110 and the substrate 170 is thus completed. The bonding structure 200 includes a substrate 170, a second metal film 160, a second inter-metallic layer 150, an inter layer 140', a first inter-metallic layer 130, a first metal film 120 and an LED wafer 110. The second metal film 160 is disposed on the substrate 170. The second inter-metallic layer 150 is disposed on the second metal film 160. The inter layer 140' is disposed on the second inter-metallic layer 150. The first inter-metallic layer 130 is disposed on the inter layer 140'. The first metal film 120 is disposed on the first inter-metallic layer 130. The LED wafer 110 is disposed on the first metal film 120.

Referring to FIG. 8, in step S107, a base of the LED wafer 110 is lifted off and the LED wafer 110 and the substrate 170 are singulated to form a plurality of LED chips 300. The present step further includes such as electrode processing, point testing and classification. Lastly, a plurality of LED chips 300 are formed.

The embodiments of the disclosure provide a method for bonding an LED wafer 110, a method for manufacturing an LED chip 300, and a bonding structure for bonding an LED wafer 110 and a substrate 170. The LED wafer 110 is bonded at a low temperature (such as lower than or equal to about 110°C), hence avoiding the thermal stress problem which arises due to the difference in the coefficients of thermal expansion. In the embodiments, the bonding process does not require high pressure, high level of flatness, or protective atmosphere.

In the embodiments, the bonding material layer 140 is metal and the melting points of the first inter-metallic layer 130, the second inter-metallic layer 150 and the temperature of the inter layer 140' after diffusion reaction can be increased to be higher than about 250°C. The LED wafer 110, the LED chip 300 and the bonding structure 200 of the disclosure have low bonding thermal stress, high dissipation performance, high bonding strength and high temperature resistance.

In one embodiment, the base with 2 inch diameter and 650 um thickness can be sputtered the first metal film 120 comprises Ag. Afterwards, a Bi film whose thickness is 500 nm, an In film whose thickness is 500 nm and a Sn film whose thickness is 1500 nm are deposited on the first metal film 120 by an Electron Beam Evaporation. Next, the base is bonded with the substrate 170 by a bonding station, such as Electron Visions EV501 Bonding Station. The material of the substrate 170 comprises silicon, and the thickness of the substrate 170 is 500 um. An Ag film whose thickness is 200 nm is sputtered on the substrate 170. In the first stage (pre-solid reaction stage), the base and the substrate are heated at 170E for 5 minutes and pressed under a 10N force. In the second stage (diffusion reaction stage), the base and the substrate 170 are heated at 170□ for 30 minutes and pressed under a 3000N force. After those two stages, Ag₂In, AgIn₂, Ag₃Sn can be observed by an electron microscope. In this embodiment, the Bi film, the In film and the Sn film are not limited to be deposited in order.

It will be apparent to those skilled in the art that various modifications and variations can be made to the disclosed embodiments. It is intended that the specification and examples be considered as exemplary only, with a true scope of the disclosure being indicated by the following claims and their equivalents.

## Claims

1. A method for bonding a light emitting diode (LED) wafer and a substrate, wherein the bonding method comprises:
forming a first metal film on the LED wafer;
forming a second metal film on the substrate;
forming a bonding material layer on the surface of the first metal film, wherein the melting point of the bonding material layer is lower than or equal to 110°C;
placing the LED wafer on the substrate for enabling the bonding material layer to contact the second metal film;
heating the bonding material layer at a pre-solid reaction temperature for a pre-solid time to perform a pre-solid reaction for forming a first inter-metallic layer between the first metal film and the bonding material layer and forming a second inter-metallic layer between the second metal film and the bonding material layer; and
heating the bonding material layer at a diffusion reaction temperature for a diffusing time to perform a diffusion reaction, wherein the melting points of the first and the second inter-metallic layers after diffusion reaction are higher than 110°C.

2. The method for bonding an LED wafer according to claim 1, wherein the pre-solid reaction temperature is 80 to 200°C, and the pre-solid time is 0.1 second to 10 minutes.

3. The method for bonding an LED wafer according to claim 1, wherein the diffusing time is 0.5 to 3 hours.

4. The method for bonding an LED wafer according to claim 1, wherein the diffusion reaction temperature is 80°C to 200°C.

5. The method for bonding an LED wafer according to claim 1, wherein the material of the first metal film comprises gold (Au), silver (Ag), copper (Cu), nickel (Ni) or a combination thereof.

6. The method for bonding an LED wafer according to claim 1, wherein the material of the bonding material layer comprises bismuth indium (Bi-In), bismuth indium zinc (Bi-In-Zn), bismuth indium tin (Bi-In-Sn), bismuth indium tin zinc (Bi-In-Sn-Zn) or a combination thereof.

7. The method for bonding an LED wafer according to claim 1, wherein the material of each of the first inter-metallic layer and the second inter-metallic layer comprises copper indium tin (Cu-In-Sn) inter-metal, nickel indium tin (Ni-In-Sn) inter-metal, nickel bismuth (Ni-Bi) inter-metal, gold indium (Au-In) inter-metal, silver indium (Ag-In) inter-metal, silver tin (Ag-Sn) inter-metal, gold bismuth (Au-Bi) inter-metal, gold tin (Au-Sn) inter-metal or a combination thereof.

8. The method for bonding an LED wafer according to claim 1, wherein the thickness of the bonding material layer is 0.2 to 5.0 micrometers.

9. A method for manufacturing a light emitting diode (LED) chip, comprising:
the method for bonding an LED wafer as claimed in claim 1; and
lifting off a base of the LED wafer and singulating the LED wafer and the substrate to form a plurality of LED chips.

10. A bonding structure comprising:
a substrate;
a second metal film located on the substrate;
a second inter-metallic layer located on the second metal film;
a first inter-metallic layer located on the second inter-metallic layer, wherein the material of each of the first inter-metallic layer and the second inter- metallic layer comprises copper indium tin (Cu-In-Sn) inter-metal, nickel indium tin (Ni-In-Sn) inter-metal, nickel bismuth (Ni-Bi) inter-metal, gold indium (Au-In) inter-metal, silver indium (Ag-In) inter-metal, silver tin (Ag-Sn) inter-metal, gold bismuth (Au-Bi) inter-metal, gold tin (Au-Sn) inter-metal or a combination thereof;
a first metal film located on the first inter-metallic layer; and
an LED wafer located on the first metal film.

11. The bonding structure according to claim 10, wherein the material of each of the first inter-metallic layer and the second inter-metallic layer comprises Ag₂In, AgIn₂ or Ag₃Sn.

12. The bonding structure according to claim 10, further comprising an inter layer interposed between the first inter-metallic layer and the second inter-metallic layer, and the material of the inter layer comprises tin (Sn), bismuth (Bi), indium (In) and zinc (Zn) or a combination thereof.

13. The bonding structure according to claim 10, wherein the material of the second metal film comprises gold (Au), silver (Ag), copper (Cu), nickel (Ni) or a combination thereof.

14. The bonding structure according to claim 10, wherein the material of the first metal film comprises gold (Au), silver (Ag), copper (Cu), nickel (Ni) or a combination thereof.
